# FASCICULE DE BREVET EUROPEEN

(11) **EP 3 956 816 B1**
(45) Date de publication et mention de la délivrance du brevet: **10.04.2024**
(21) Numéro de dépôt: 20728531.3
(22) Date de dépôt: 16.04.2020
(51) Int. Cl.: G06K 19/07, G06V 40/13

(54) **MODULE DE CAPTEUR BIOMÉTRIQUE POUR CARTE À PUCE ET PROCÉDÉ DE FABRICATION D'UN TEL MODULE**
BIOMETRISCHES SENSORMODUL FÜR EINE CHIPKARTE UND VERFAHREN ZUR HERSTELLUNG EINES SOLCHEN MODULS
BIOMETRIC SENSOR MODULE FOR A SMART CARD AND METHOD FOR MANUFACTURING SUCH A MODULE

(30) Priorité: 19.04.2019 FR 1904204
(43) Date de publication de la demande: 23.02.2022
(73) Titulaire: Linxens Holding, 78200 Mantes-la-Jolie (FR)
(72) Inventeur: MATHIEU, Christophe, 78200 MANTES-LA-JOLIE (FR); NIELAND, Carsten, 99867 GOTHA (DE)
(74) Mandataire: INNOV-GROUP
(86) Numéro de dépôt international: PCT/FR2020/000129
(87) Numéro de publication internationale: WO 2020/212661

(56) Documents cités:
- DE-A1- 10 139 414
- FR-A1- 3 061 333
- FR-A1- 3 063 555
- US-A1- 2017 277 936

## Description

### Domaine technique

L'invention concerne le domaine de la carte à puce.

### Etat de la technique

Dans le domaine de la carte à puce, et notamment dans celui des cartes à puce utilisées comme moyen de paiement, les fabricants souhaitent offrir toujours davantage de sécurité aux utilisateurs. Ainsi, il a été proposé d'intégrer, à des cartes à puce, des capteurs biométriques pour la lecture d'empreintes digitales. On peut se référer aux demandes de brevet DE10139414A1 et US20170277936A1 pour des exemples de telles cartes.

Par exemple, pour les cartes bénéficiant de modes de lecture avec et sans contact, un module intégré à la carte et comprenant un capteur biométrique peut permettre de n'autoriser une transaction que si l'empreinte digitale du titulaire de la carte est détectée. Ce type de carte est par exemple décrit dans le document de brevet publié sous le numéro EP 3 336 759 A1. Pour réaliser une telle carte, une cavité est fraisée dans la carte, pour mettre à nu un circuit électrique préalablement intégré dans le corps de la carte, et y loger le module. Le module alors logé dans cette cavité est aussi électriquement connecté au circuit.

L'intégration dans la carte d'un module comportant un capteur biométrique est une opération délicate. En effet, la connexion du module au circuit électrique de la carte doit être fiable, stable dans le temps, ne pas engendrer de dégradation du capteur, ne pas impacter négativement l'esthétique de la carte, etc.

Un but de l'invention est de contribuer au moins partiellement à faciliter l'intégration du module dans la carte.

### Résumé de l'invention

Ainsi il est proposé selon l'invention un module de capteur biométrique pour carte à puce, selon la revendication 1.

Dans ce module au moins un plot de connexion comporte une zone mouillable par un matériau de soudure, cette zone s'étendant sur une aire comprise entre 0,2 et 5 millimètres carrés et avantageusement égale ou supérieure à 0,79 millimètres carrés.

Ainsi, grâce à ces dimensions de l'aire de la zone mouillable par un matériau de soudure, on parvient à maîtriser la forme de la goutte (ou perle) de matériau de soudure qui sera déposée sur les plots de connexion. Dans ce document on utilise le terme « goutte » pour désigner le matériau de soudure aussi bien avant que celui-ci ne soit déposé sur un plot de connexion, qu'après son dépôt sur un plot de connexion (En anglais, il est courant d'utiliser le terme « drop » avant dépôt sur un plot de connexion et « solder bump » lorsque le matériau de soudure est déposé sur un plot de connexion). En général, dans ce texte le terme « goutte » désigne la forme du matériau de soudure déposé sur un plot de connexion, mais le cas échéant, l'homme du métier comprendra d'après le contexte dans lequel le terme « goutte » est utilisé, si ce terme désigne éventuellement le matériau de soudure qui n'est pas encore déposé sur un plot de soudure. Cette goutte de matériau de soudure peut être obtenue par exemple en déposant le matériau sur la zone mouillable et en utilisant une technique de refusion (« reflow » en anglais) ou par dépôt de la goutte sous forme liquide puis refroidissement. La forme maîtrisée de la goutte de matériau de soudure peut permettre d'avoir une hauteur de matériau de soudure suffisante pour connecter les plots de connexion au circuit de la carte, sans toutefois que le matériau de soudure ne flue de manière incontrôlée, par exemple lors d'une refusion au moins partielle du matériau de soudure pendant l'encartage du module, et ne remonte entre le module et les parois de la cavité notamment, jusqu'en surface de la carte.

Ce module de carte à puce comprend éventuellement l'une et/ou l'autre des caractéristiques suivantes, considérées chacune indépendamment l'une de l'autre, ou chacune en combinaison d'une ou plusieurs autres :
- au moins un plot de connexion a une zone mouillable par un matériau de soudure délimitée par un pourtour essentiellement continu ayant une forme choisie parmi le rectangle, le losange, le carré, l'ovale, ou le rond ;
- au moins un plot de connexion comporte des extensions s'étendant depuis la zone mouillable par un matériau de soudure, vers une extrémité libre ;
- une goutte de matériau de soudure est déposée sur la zone mouillable d'au moins un plot de connexion, cette goutte ayant un volume compris entre 0,002 et 0,070 millimètres cubes ;
- le matériau de soudure est un alliage ayant une température de fusion inférieure ou égale à 140°C , par exemple compris dans la liste constitué de l'étain/bismuth, de l'étain/bismuth/argent et de l'étain/indium ;
- la goutte de matériau de soudure a une hauteur mesurée, perpendiculairement au support, entre la surface du plot de connexion sur lequel elle est déposée et son sommet, comprise entre 0,020 et 0,200 millimètres et plus préférentiellement entre 0,040 et 0,150 millimètres ;
- le support diélectrique est un support flexible d'une famille comprise dans la liste constituée des polyimides, des polyéthylènes terephthalates (PET et PET copolymères), des polyéthylènes naphthalates et des verres epoxy.

Selon un autre aspect, l'invention concerne une carte à puce comprenant un module de capteur biométrique selon l'invention. Cette carte à puce comprend un corps de carte avec un circuit électrique intégré dans le corps de carte. Le module et le circuit sont électriquement connectés l'un à l'autre à l'aide d'un matériau de soudure.

Cette carte à puce comprend éventuellement l'une et/ou l'autre des caractéristiques suivantes, considérées chacune indépendamment l'une de l'autre, ou chacune en combinaison d'une ou plusieurs autres :
- le module et le circuit sont électriquement connectés à l'aide d'un matériau de soudure déposé sur au moins un plot de connexion dont la température de fusion est inférieure ou égale à 140°C ;
- le module et le circuit sont électriquement connectés à l'aide d'un matériau de soudure déposé sur au moins un plot de connexion et d'un matériau de soudure déposé sur le circuit, la température de fusion du matériau de soudure déposé sur au moins un plot de connexion étant inférieure ou égale à celle du matériau de soudure déposé sur le circuit.

Selon encore un autre aspect, l'invention concerne un procédé de fabrication d'un module de capteur biométrique pour carte à puce, selon la revendication 11.

Ce procédé comprend éventuellement l'une et/ou l'autre des caractéristiques suivantes, considérées indépendamment les unes des autres ou chacune en combinaison d'une ou plusieurs autres :
- on dépose une goutte de soudure sur un plot de connexion ;
- le matériau de soudure est déposé sur un plot de connexion à l'aide d'une technique comprise dans la liste constitué du jet, de la mise en place d'une bille de matériau de soudure (« solder ball » en anglais), de la dispense de matériau de soudure sous forme liquide ou pâteuse, de l'impression du matériau de soudure sous forme liquide ou pâteuse (sérigraphie ou « screen printing » en anglais), par transfert au bout d'une pointe (« pin transfer » en anglais) du matériau de soudure sous forme liquide ou pâteuse, de la mise en place à partir du matériau de soudure préformé (« solder preform » en anglais), suivie ou non d'une étape de refusion ;
- le matériau de soudure est déposé sur un plot de connexion après que le capteur biométrique ait été attaché à la face arrière du support ; et
- on attache le capteur biométrique sur la face arrière du support à l'aide d'un adhésif pour fixation de puces réticulant à des températures comprises entre 100°C et 150°C .

### Brève description des dessins

D'autres aspects, buts et avantages de l'invention apparaîtront à la lecture de la description détaillée qui suit, ainsi qu'à l'aide des dessins annexés, donnés à titre d'exemples non-limitatifs et sur lesquels :
[Fig.1] représente schématiquement en perspective une carte à puce conforme à un premier exemple de mode de réalisation de l'invention ;
[Fig.2] représente schématiquement en perspective une carte à puce conforme à un deuxième exemple de mode de réalisation de l'invention ;
[Fig.3] représente schématiquement en coupe, différentes étapes d'un exemple de procédé de fabrication d'un module de capteur biométrique tel que celui intégré à la carte représentée sur la figure 2 ;
[Fig.4] représente schématiquement en coupe, l'intégration dans une carte d'un module de capteur biométrique obtenu à l'aide d'un procédé tel que celui illustré par la figure 3 ;
[Fig.5] représente schématiquement différentes variantes envisageables pour la forme des plots de connexion placés en face arrière d'un module de capteur biométrique obtenu à l'aide d'un procédé tel que celui illustré sur la figure 3 ; et
[Fig.6] représente schématiquement encore d'autres variantes envisageables pour la forme des plots de connexion placés en face arrière d'un module de capteur biométrique obtenu à l'aide d'un procédé tel que celui illustré sur la figure 3.

### Description détaillée

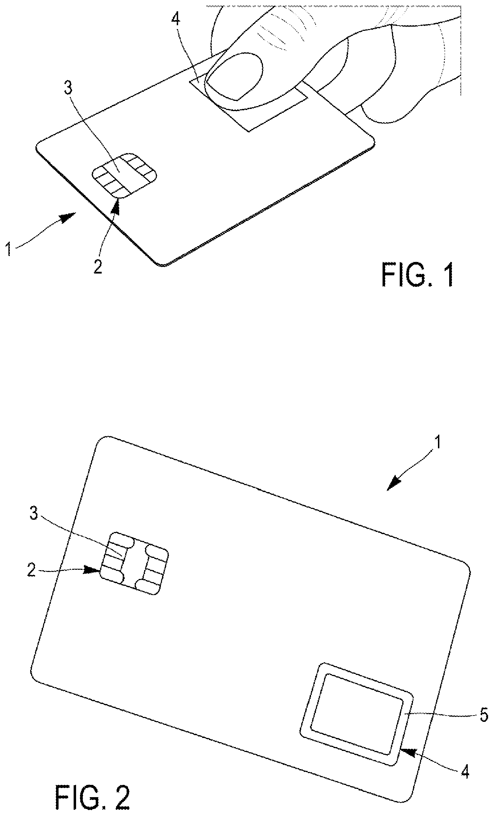

Un exemple de carte à puce 1 selon l'invention est représenté sur la figure 1. Selon cet exemple, la carte 1 est une carte bancaire au format ID-1. On notera qu'il ne s'agit bien que d'un exemple et que l'invention peut être appliquée à d'autres types de cartes (cartes d'accès contrôlé, cartes d'identité, cartes de transport, cartes d'accès logique (« logical access control » en anglais), etc.). Cette carte 1 comporte un premier module 2 comprenant un connecteur 3 et une puce électronique (sous le connecteur). Le connecteur 3 permet de connecter électriquement la puce électronique à un lecteur de cartes, pour échanger des données entre la puce et le lecteur de cartes.

Dans le cas des cartes à double interface, c'est-à-dire permettant une lecture par contact ou sans contact, cette carte 1 comporte également une antenne intégrée dans le corps de la carte 1. Cette antenne est connectée par exemple à la puce située dans le premier module 2. Cette antenne permet d'échanger sans contact des données entre la puce et un lecteur de cartes sans contact. Cette antenne, ou une autre partie d'un circuit électrique situé dans le corps de la carte 1, est également connectée électriquement à un deuxième module 4 intégré à la carte 1. Le deuxième module 4 est un module biométrique. Ce module biométrique 4 comprend un capteur pour la reconnaissance d'empreintes digitales. Le deuxième module 4 permet de déterminer si l'empreinte digitale lue par le capteur correspond à celle d'un utilisateur qui a l'autorisation de se servir de cette carte 1. Dans ce cas, une communication sans contact entre la puce et un lecteur peut être autorisée.

L'exemple de mode de réalisation de la carte 1 représentée sur la figure 2, diffère de celui représenté sur la figure 1, essentiellement par le fait que le deuxième module 4 comporte un contour conducteur 5 (« bézel » 5 en anglais) continu ou non. Le bézel 5 est relié électriquement au capteur biométrique situé en face arrière du deuxième module 4. Il permet d'évacuer d'éventuelles charges électrostatiques qui pourraient détériorer le capteur ou empêcher la lecture d'une empreinte digitale par le capteur. Sur la figure 2, le bézel 5 a une forme annulaire continue. Selon des variantes, le bézel 5 peut être constitué de plusieurs segments, ou points, conducteurs agencés autour de la zone sur laquelle doit être placé un doigt pour lire l'empreinte digitale correspondante.

Le procédé de fabrication d'un module du type de celui illustré sur la figure 2 est décrit ci-dessous.

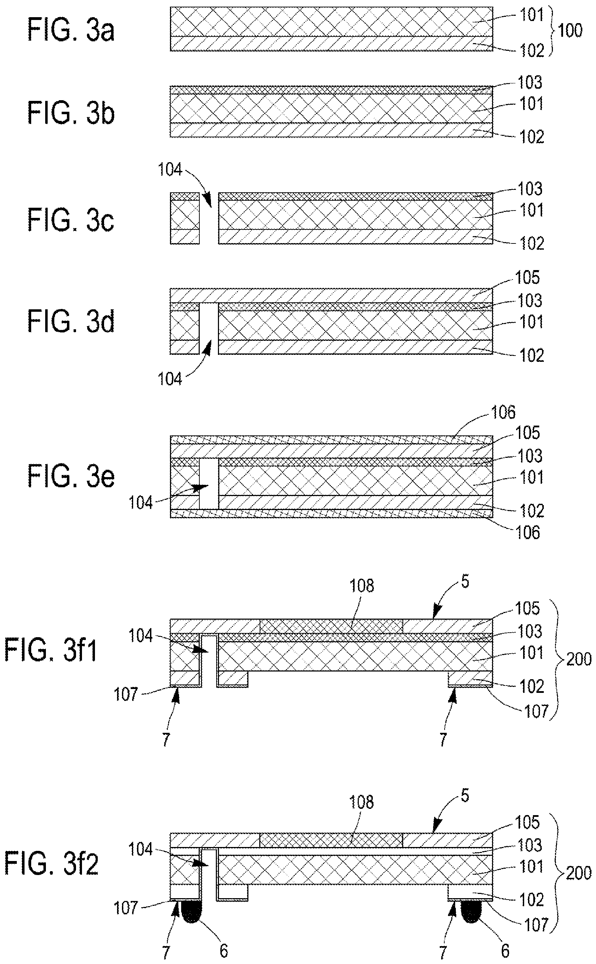

Ce procédé comprend :
- La fourniture d'un matériau complexe 100 comprenant un support 101 de matériau diélectrique sur lequel est laminé un feuillet constitué d'un premier matériau électriquement conducteur 102 (voir figure 3a) ; par exemple le matériau diélectrique est un poly-imide dont l'épaisseur est comprise entre 25 et 75 micromètres, et est préférentiellement égale à 50 micromètres et le premier matériau électriquement conducteur 102 est un alliage de cuivre dont l'épaisseur est comprise entre 12 et 35 micromètres, et est préférentiellement égale à 18 micromètres ; pour une mise en oeuvre du procédé selon l'invention performante au plan industriel, ce matériau complexe 100 (« copper clad » en anglais) est avantageusement fourni en rouleau et le procédé est mis en oeuvre de rouleau à rouleau (« reel-to-reel » en anglais) ;
- L'enduction, avec un matériau adhésif 103, de la face du matériau diélectrique opposée à celle sur laquelle est laminé le premier matériau électriquement conducteur (voir figure 3b) ; le matériau adhésif 103 est par exemple une résine de type époxy, éventuellement modifiée avec des résines et des charges minérales ; le matériau adhésif 103 est ainsi déposé sur une épaisseur comprise entre 10 et 25 micromètres ; le matériau adhésif 103 subit éventuellement un procédé de séchage en continu pour évacuer les solvants présents dans la formulation au moment de son dépôt ;
- La perforation de trous 104 traversant le nouveau matériau complexe comprenant le support diélectrique 101, la couche du premier matériau électriquement conducteur 102 et la couche de matériau adhésif 103 (voir figure 3c) ;
- La lamination d'une couche d'un deuxième matériau électriquement conducteur 105 ; par exemple, ce deuxième matériau électriquement conducteur est un alliage de cuivre dont l'épaisseur est comprise entre 12 et 35 micromètres, préférentiellement cette épaisseur est égale à 18 micromètres; cette couche constituée du deuxième matériau électriquement conducteur 105 obture les trous 104 (voir figure 3d) ; le matériau adhésif 103 subit éventuellement une étape de réticulation selon un cycle défini avec des paliers de températures adaptés à la chimie de matériau adhésif 103 ;
- La lamination d'un film sec de résine photosensible 106 sur chacune des deux faces principales du complexe obtenu à l'issue de l'étape précédente (voir figure 3e), puis l'insolation à travers un masque, et la révélation de la résine photosensible pour former des motifs utilisés lors d'étapes subséquentes
   _ de gravure sur certaines zones des couches de premier 102 et deuxième 105 matériaux électriquement conducteurs ;
   _ de dépôts électrolytiques de couches de métaux 107 (cuivre, nickel, or, palladium, argent par exemples) destinés à faciliter la soudure de fils de connexion sur le deuxième matériau conducteur et/ou à réaliser des vias conducteurs entre le premier 102 et le deuxième 105 matériau conducteur au niveau des trous 104 ;
   _ de dépôt d'une couche d'un matériau de protection 108 sur une zone de détection ; ce matériau de protection 108 est, par exemple, un matériau de couverture photoimageable (« photoimageable coverlay » en anglais), c'est-à-dire un matériau photosensible ; par exemple, la couche de matériau de protection 108 a une épaisseur comprise entre 15 et 50 micromètres, et est par exemple égale à 25 micromètres ; par exemple, la couche de matériau de protection 108 est déposée en film laminé sur la face avant du support 101 ; par exemple, la couche de matériau de protection 108 est déposée sous forme d'un film d'époxy-acrylate (par exemple Par exemple, il s'agit du produit commercialisé sous la référence par la société Ethernal (www.eternal-group.com) ; alternativement, la couche de matériau de protection 108 est déposée en utilisant une technique de sérigraphie ; alternativement encore, la couche de matériau de protection 108 est déposée par une technique semblable à celle du jet d'encre ; alternativement encore, la couche de matériau de protection 108 est déposée par une technique d'enduction ; la couche de protection 108 s'étend en face avant sur une surface correspondant à une zone de détection ; et
   _ dans les cas des où le dépôt de la couche d'un matériau de protection 108 est réalisé par une technique de dépôt non sélective, après dépôt de la couche du matériau de protection 108, il peut être nécessaire de réaliser une étape d'exposition à un rayonnement approprié à travers un masque, suivie d'une étape de développement chimique ;
   _ une étape de réticulation thermique de la couche de protection.

Grâce à la couche de matériau de protection 108 constituée du matériau de couverture photoimageable, il est possible de protéger le support 101 avec un matériau relativement résistant mécaniquement et chimiquement, dont l'emploi peut être aisément intégré dans un procédé industriel, notamment dans un procédé mis en oeuvre de rouleau à rouleau, et compatible avec des étapes de chauffage nécessaires à une éventuelle connexion par soudure du module 4 au circuit 200 déjà intégré dans le corps d'une carte. Son caractère photoimageable est en outre compatible avec la mise en oeuvre d'étapes de photo-lithographie maîtrisables industriellement et compatibles avec de hauts rendements.

Préférentiellement, la couche de protection 108 comprenant le matériau de couverture photoimageable est à base de résines époxy-acrylates dont les propriétés physico-chimiques, notamment en termes de dureté et de résistance à l'abrasion, sont après réticulation UV ou thermique supérieures à celles que l'on pourrait obtenir avec de purs acrylates, par exemple. De même, les résines epoxy-acrylates sont plus faciles à mettre en oeuvre que les résines époxy

Selon un mode particulier de mise en oeuvre du procédé selon l'invention, on réalise un dépôt d'un matériau de soudure 6 sur des plots de connexion 7 réalisés au cours des étapes précédentes dans la couche du premier matériau conducteur 102. Par exemple le matériau de soudure 6 est un alliage d'étain-bismuth, d'étain-bismuth-argent, d'étain-indium. Par exemple le matériau de soudure 6 est déposé par sérigraphie ou par jet (ou par d'autres méthodes comme indiqué plus haut). En outre, au lieu de rendre les trous 104 conducteurs à l'aide de dépôts électrolytiques de couches de métaux 107, on peut aussi profiter de cette étape de dépôt d'un matériau de soudure 6 pour déposer celui-ci dans les trous 104 et les rendre ainsi conducteurs entre les couches du premier 102 et du deuxième 105 matériaux conducteurs.

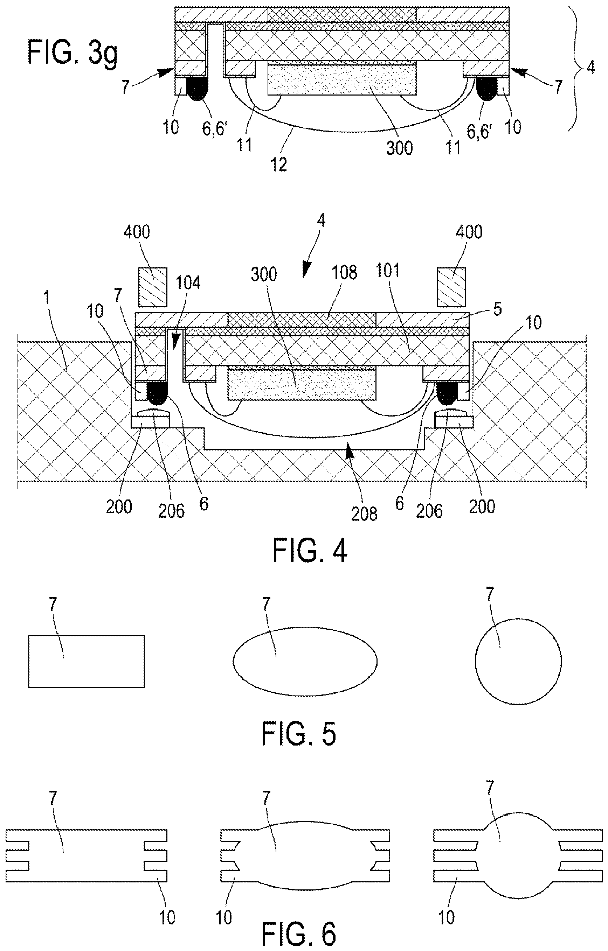

Le matériau de soudure 6 peut être déposé sur des plots de connexion 7 de différentes formes (voir figure 5). Par exemple, ces formes ont un pourtour essentiellement continu qui délimite une zone mouillable par un matériau de soudure, cette zone mouillable par un matériau de soudure ayant une forme rectangulaire, de losange (éventuellement carrée), ovale, ou ronde.

Alternativement, au lieu de déposer un matériau de soudure 6 sur les plots de connexion 7, ils sont laissés vierges, jusqu'à l'opération d'encartage du module 4 dans la carte 1. Alors, lors de l'opération d'encartage, préalablement à la mise en place du module 4 dans la cavité 208 ménagée (par exemple par fraisage) dans le corps de carte, un matériau de soudure 6, une pâte ou un film conducteur anisotrope 6' est déposé sur les plots de connexion 7, afin d'établir une connexion avec le circuit 200 logé dans le corps de carte (voir figures 3g et 4). Lorsqu'une pâte ou un film conducteur anisotrope 6' est utilisé, les plots de connexion 7 peuvent avoir une forme telle que celles décrites ci-dessus en relation avec la figure 5 ou bien ils peuvent avoir une forme avec des extensions 10 permettant un meilleur accrochage de la pâte ou une meilleure performance en termes de conductibilité électrique du film conducteur anisotrope 6' sur les plots de connexion 7.

Mais plus avantageusement, les plots de connexion 7 ont une forme compatible aussi bien avec l'utilisation d'un matériau de soudure 6, qu'avec une pâte ou un film conducteur anisotrope 6'. A cette fin, les plots de connexion 7 peuvent avoir des formes comprenant une zone mouillable par un matériau de soudure délimitée par un pourtour essentiellement continu ayant une forme choisie parmi le rectangle, le losange, le carré, l'ovale, ou le rond, ainsi que des extensions 10 latérales s'étendant depuis la zone mouillable par un matériau de soudure, vers une extrémité libre (voir figure 6).

A l'issue des étapes ci-dessus, on obtient un rouleau supportant des supports 200 de capteur biométrique pour carte à puce. Chacun de ces supports 200 a une structure correspondant par exemple à celle représentée sur la figure 3f1 ou la figure 3f2 selon que le capteur biométrique est assemblé avant ou après le dépôt de la pâte à souder 6 sur les plages 7. Chaque support 200 comprend donc :
- Une face avant, avec un bézel 5 formé dans la couche du deuxième matériau conducteur 105, et une couche de protection 108 déposée sur la couche de matériau adhésif 103, au niveau d'une zone de détection située à l'intérieur de l'anneau formé par le bézel 5 ;
- Une face arrière avec des plots de connexion 7, éventuellement avec une goutte d'un matériau de soudure 6 déposée sur au moins certains de ces plots de connexion 7 afin de pouvoir connecter ultérieurement un module 4 à un circuit 200 intégré dans le corps de carte.

En vue de son utilisation et de son intégration dans une carte à puce, chaque support 200 est muni d'un capteur biométrique 300 d'empreintes digitales. Ce capteur biométrique 300 est fixé sur la face arrière, par exemple, par une technologie connue de fixage de puce (« die attach » en anglais). Par exemple, on fixe le capteur biométrique 300 sur la face arrière du support 101 à l'aide d'un adhésif thermodurcissable à des températures comprises entre 100°C et 150°C et qui possède la caractéristique de migrer par capillarité sous la totalité de la surface du capteur sans générer de vide, ni de bulles (« underfill » en anglais).

Le dépôt d'un matériau de soudure 6 sur des plots de connexion 7 est réalisé avant ou après assemblage du capteur biométrique 300, mais préférentiellement après pour éviter que le capteur biométrique 300 ne subisse un choc thermique lors de l'opération de refusion de la pâte à souder formant le matériau de soudure 6.

De même, le matériau de soudure 6 est déposé par sérigraphie ou par jet (ou par d'autres méthodes comme indiqué plus haut).

Préférentiellement, le dépôt du matériau de soudure 6 sur des plots de connexion 7 est réalisé par jet si le capteur biométrique 300 est déjà assemblé sur le support diélectrique 101.

Le capteur biométrique 300 occupe, sur la face arrière, une surface correspondant essentiellement à une aire de détection située en vis-à-vis de la zone de détection sur laquelle est déposée la couche de protection 108. Ce capteur biométrique 300 est connecté aux plots de connexion 7 et au bézel 5 à l'aide d'une technologie connue, telle que la technologie de la puce renversée (« flip chip » en anglais) ou la connexion par fils conducteurs 11 (« wire bonding » en anglais). Avantageusement, le capteur biométrique 300 et ses éventuels fils conducteurs 11 sont protégés dans une résine d'encapsulation 12. Un adhésif thermofusible 10 (« hot melt » en anglais) est, éventuellement, également disposé en face arrière sur, ou à côté, des plots de connexion 7. Cet adhésif thermofusible 10 est destiné à fixer le module 4 de capteur biométrique dans la cavité 208 ménagée dans le corps d'une carte à puce.

Lors de l'encartage du module 4 dans un corps de carte, pour établir une connexion entre les plots de connexion 7 du module et le circuit 200 qui est intégré dans le corps de carte, plusieurs options sont possibles. On peut par exemple souder directement les plots de connexion 7 au circuit 200 à l'aide du matériau de soudure 6 déposé sur les plots de connexion 7 (voir figure 4). Alternativement, on peut déposer sur le circuit 200 des gouttes 206 d'un matériau de soudure et réaliser une connexion entre les plots de soudure 7 et le circuit 200 par fusion de l'un, de l'autre, ou des deux matériaux de soudure ayant été préalablement déposés, chacun respectivement, sur les plots de connexion 7 et sur le circuit 200. Plus particulièrement, par exemple on peut déposer un premier matériau de soudure 6 sur les plots de connexion 7 et un deuxième matériau de soudure 206 sur le circuit 200. Le deuxième matériau de soudure est préférentiellement déposé sur le circuit 200 avant finalisation du corps de carte (c'est-à-dire avant empilement et lamination des différentes couches constitutives de la carte à puce 1). Le premier matériau de soudure 6 est alors avantageusement un matériau de soudure ayant une température de fusion à basse température de fusion (par exemple une température de fusion inférieure ou égale à 140°C), le deuxième matériau de soudure 206 ayant une température de fusion plus haute, voisine ou identique à celle du premier matériau de soudure 6. Avantageusement, l'utilisation d'un deuxième matériau de soudure 206 à plus haute température de fusion permet de limiter le risque d'un fluage du ou des matériaux de soudure dans et vers le bord de la cavité 208, voire à l'extérieur de celle-ci.

Par exemple, pour réaliser la connexion des plots de connexion 7 avec le circuit 200, on place une thermode 400 sur le bézel 5. Le bézel 5 étant avantageusement en vis-à-vis des plots de connexion 7 de part et d'autre du support 101, la conduction thermique s'effectue ainsi particulièrement bien entre les deux faces du support 101.

En utilisant un premier matériau de soudure 6 à basse température de fusion (inférieure ou égale à 140°C) sur les plots de connexion 7 et un deuxième matériau de soudure 206 à plus haute température sur le circuit 200, la thermode 400, chauffée par exemple à une température de 230°C est appliquée pendant 2,5 secondes. La chaleur fournie par la thermode 400 diffuse également au niveau de l'adhésif thermofusible 10 pour coller le module 4 dans la carte 1.

En utilisant, un premier matériau de soudure 6 à basse température de fusion (inférieure ou égale à 140°C) sur les plots de connexion 7 et un deuxième matériau de soudure 206, sur le circuit 200, ayant une température de fusion égale, voisine, ou inférieure, à celle du premier matériau de soudure 6, la thermode 400, chauffée par exemple à une température de 230°C est appliquée pendant 1.5 secondes. Le procédé selon est donc, dans ce cas, plus rapide. En outre, l'utilisation de matériaux de soudure 6, 206 à basse température de fusion, permet de mettre en oeuvre une thermode 400 avec une surface portante plus limitée, ce qui peut contribuer à mieux maitriser le fluage et à limiter les risques de déformation de la carte 1 et/ou du module 4.

D'une manière générale, pour connecter le module 4 au circuit 200, on peut utiliser une colle ou pâte électriquement conductrice 6', un film anisotrope conducteur ou un matériau de soudure 6. Mais dans tous les cas, avantageusement, on utilise le procédé décrit ci-dessus ou des variantes de celui-ci, en réalisant des plots de connexion 7 ayant une forme compatible aussi bien avec l'utilisation d'un matériau de soudure 6, qu'avec une pâte ou un film conducteur anisotrope 6', cette forme pouvant être rectangulaire, correspondre à un losange, carrée, ovale, ou en forme de disque, avec en outre des extensions 10 latérales (voir figure 6). Le module 4 selon l'invention est alors le même qu'il soit connecté par soudure ou à l'aide d'un adhésif conducteur. Cela permet de fabriquer le module 4 en plus grandes séries tout en laissant la possibilité à l'encarteur de choisir l'une ou l'autre des technologies de connexion.

Il a été décrit en relation avec les figures 2, 3 et 4, la réalisation et l'encartage d'un module 4 comprenant un bézel 5 en face avant. Dans le cas, par exemple, où le capteur biométrique 300 n'est pas ou peu sensible aux charges électrostatiques, on peut se dispenser de bézel 5 (voir figure 1). Le procédé décrit ci-dessus est alors aisément simplifié. On peut en effet se dispenser de réaliser des trous 104. On peut également n'utiliser qu'un seul feuillet de matériau conducteur 102 (on supprime ainsi notamment les étapes illustrées par les figures 3c et 3d). Le matériau conducteur 102 est alors placé uniquement sur la face arrière du support 101, pour former les plots de connexion 7. La couche de protection 108 est réalisée de manière à recouvrir au moins la zone de détection située en vis-à-vis l'aire de détection du capteur 300. La couche de protection 108, outre sa fonction de protection proprement dite du support 101, indique où placer le doigt pour en détecter l'empreinte. La couche de protection 108 peut être teintée de différentes couleurs afin, par exemple, de s'harmoniser avec la couleur de la carte 1.

La couche de protection 108 est éventuellement constitué d'une encre ou comprend une encre. Par exemple, il s'agit d'une encre à base d'époxy-acrylate. Par exemple, il s'agit du produit commercialisé sous la référence SD 2444 NB-M par la société Peters (www.peters.de).

## Revendications

1. Module de capteur biométrique pour carte à puce, comprenant
- un support (101) diélectrique comportant une face avant et une face arrière, formant toutes deux des faces principales du support (101),
- un capteur biométrique (300) pour la détection d'empreintes digitales attaché à la face arrière et s'étendant sous la face arrière sur une aire de détection située en vis-à-vis d'une zone de détection située sur la face avant du support (101), la zone de détection étant configurée pour recevoir un doigt dont l'empreinte est détectée par le capteur,
- des plots de connexion (7) électriquement conducteurs, disposés sur la face arrière du support (101) et reliés électriquement au capteur biométrique (300), **caractérisé par le fait qu'**au moins un plot de connexion (7) comporte une zone mouillable par un matériau de soudure, s'étendant sur une aire comprise entre 0,2 et 5 millimètres carrés et **par le fait que** le plot de connexion (7) est placé essentiellement en vis-à-vis d'une zone de la face avant recouverte par un bézel (5) et au moins un via conducteur (104) est réalisé dans l'épaisseur du support (101), ce via (104) reliant électriquement le bézel (5) au plot de connexion (7).

2. Module selon la revendication 1, dans lequel au moins un plot de connexion (7) a une zone mouillable par un matériau de soudure délimitée par un pourtour essentiellement continu ayant une forme choisie parmi le rectangle, le losange, le carré, l'ovale, ou le rond.

3. Module selon la revendication 2, dans lequel au moins un plot de connexion (7) comporte des extensions (10) s'étendant depuis la zone mouillable par un matériau de soudure, vers une extrémité libre.

4. Module selon l'une des revendications précédentes, dans lequel une goutte de matériau de soudure (6) est déposée sur la zone mouillable d'au moins un plot de connexion (7), cette goutte ayant un volume compris entre 0,002 et 0,070 millimètres cubes.

5. Module selon la revendication 4, dans lequel le matériau de soudure est un alliage ayant une température de fusion inférieure ou égale à 140°C et compris dans la liste constituée de l'étain/bismuth et de l'étain/bismuth/argent et de l'étain/indium.

6. Module selon l'une des revendications 4 et 5, dans lequel la goutte de matériau de soudure (6) a une hauteur mesurée, perpendiculairement au support (101), entre la surface du plot de connexion (7) sur lequel elle est déposée et son sommet, comprise entre 0,040 et 0,150 millimètres.

7. Module selon l'une des revendications précédentes, dans lequel le support (101) diélectrique est un support flexible de la famille des polyimides.

8. Carte à puce comprenant un corps de carte avec un circuit (200) électrique intégré dans le corps de carte et un module (4) selon l'une des revendications précédentes, le module (4) et le circuit (200) étant électriquement connectés à l'aide d'un matériau de soudure (6).

9. Carte à puce selon la revendication 8, dans laquelle le module (4) et le circuit (200) sont électriquement connectés à l'aide d'un matériau de soudure (6) déposé sur au moins un plot de connexion (7) dont la température de fusion est inférieure ou égale à 140°C.

10. Carte à puce selon la revendication 8 ou 9, dans laquelle le module (4) et le circuit (200) sont électriquement connectés à l'aide d'un matériau de soudure (6) déposé sur au moins un plot de connexion (7) et d'un matériau de soudure (206) déposé sur le circuit (200), la température de fusion du matériau de soudure (6) déposé sur au moins un plot de connexion (7) étant inférieure ou égale à celle du matériau de soudure (206) déposé sur le circuit (200).

11. Procédé de fabrication d'un module (4) de capteur biométrique pour carte à puce, comprenant des étapes au cours desquelles
- on fournit un support (101) diélectrique comportant une face avant et une face arrière, formant toutes deux des faces principales du support (101),
- on attache un capteur biométrique (300) pour la détection d'empreintes digitales à la face arrière, une aire de détection couverte par le capteur sur la face arrière étant placée en vis-à-vis d'une zone de détection située sur la face avant du support (101), la zone de détection étant configurée pour recevoir un doigt dont l'empreinte est détectée par le capteur,
- on réalise des plots de connexion (7) électriquement conducteurs, sur la face arrière du support (101) et reliés électriquement au capteur biométrique (300), **caractérisé par le fait qu'**au moins un plot de connexion (7) comporte une zone mouillable par un matériau de soudure, s'étendant sur une aire comprise entre 0,2 et 5 millimètres carrés et **par le fait que** le plot de connexion (7) est placé essentiellement en vis-à-vis d'une zone de la face avant recouverte par un bézel (5) et au moins un via conducteur (104) est réalisé dans l'épaisseur du support (101), ce via (104) reliant électriquement le bézel (5) au plot de connexion (7)..

12. Procédé selon la revendication 11, dans lequel on dépose une goutte de soudure (6) sur un plot de connexion (7).

13. Procédé selon la revendication 12, dans lequel le matériau de soudure (6) est déposé par jet sur un plot de connexion (7).

14. Procédé selon la revendication 12 ou 13, dans lequel le matériau de soudure (6) est déposé sur un plot de connexion (7) après que le capteur biométrique (300) ait été attaché à la face arrière du support (101).

15. Procédé selon l'une des revendications 11 à 14, dans lequel on attache le capteur biométrique (300) sur la face arrière du support (101) à l'aide d'un adhésif pour fixation de puces réticulant à des températures comprises entre 100°C et 150°C.

## Patentansprüche

1. Biometrisches Sensormodul für eine Chipkarte, umfassend:
- einen dielektrischen Träger (101), der eine Vorderseite und eine Rückseite aufweist, die beide jeweils eine Hauptseite des Trägers (101) bilden,
- einen biometrischen Sensor (300) zur Erkennung digitaler Fingerabdrücke, der an der Rückseite angebracht ist und sich unter der Rückseite auf einer Detektionsfläche erstreckt, der sich gegenüber einem Detektionsbereich befindet, der sich auf der Vorderseite des Trägers (101) befindet, wobei der Detektionsbereich dafür ausgelegt ist, einen Finger aufzunehmen, dessen Abdruck von dem Sensor erkannt wird,
- elektrisch leitende Anschlusspads (7), die auf der Rückseite des Trägers (101) angeordnet sind und mit dem biometrischen Sensor (300) elektrisch verbunden sind, **dadurch gekennzeichnet, dass** mindestens ein Anschlusspad (7) einen mit einem Schweißmaterial benetzbaren Bereich aufweist, der sich auf einer Fläche zwischen 0,2 und 5 Quadratmillimetern erstreckt, und dadurch, dass das Anschlusspad (7) im Wesentlichen gegenüber einem Bereich der Vorderseite angeordnet ist, der von einer Einfassung (5) bedeckt ist, und mindestens ein leitendes Kontaktloch (104) in der Dicke des Trägers (101) ausgebildet ist, wobei dieses Kontaktloch (104) die Einfassung (5) mit dem Anschlusspad (7) elektrisch verbindet.

2. Modul nach Anspruch 1, wobei mindestens ein Anschlusspad (7) einen mit einem Schweißmaterial benetzbaren Bereich aufweist, der von einem im Wesentlichen durchgehenden Umfang begrenzt wird, der eine Form aufweist, die aus einem Rechteck, einem Rhombus, einem Quadrat, einem Oval und einem Kreis ausgewählt ist.

3. Modul nach Anspruch 2, wobei mindestens ein Anschlusspad (7) Verlängerungen (10) aufweist, die sich von dem mit einem Schweißmaterial benetzbaren Bereich zu einem freien Ende hin erstrecken.

4. Modul nach einem der vorhergehenden Ansprüche, wobei ein Tropfen Schweißmaterial (6) auf den benetzbaren Bereich mindestens eines Anschlusspads (7) aufgebracht ist, wobei dieser Tropfen ein Volumen zwischen 0,002 und 0,070 Kubikmillimetern aufweist.

5. Modul nach Anspruch 4, wobei das Schweißmaterial eine Legierung ist, die eine Schmelztemperatur aufweist, die kleiner oder gleich 140 °C ist, und die in der Liste enthalten ist, die aus Zinn/Wismut und Zinn/Wismut/Silber und Zinn/Indium besteht.

6. Modul nach einem der Ansprüche 4 und 5, wobei der Tropfen Schweißmaterial (6) eine senkrecht zum Träger (101) gemessene Höhe zwischen dem Anschlusspad (7), auf das er aufgebracht ist, und seinem Scheitel aufweist, die zwischen 0,040 und 0,150 Millimeter beträgt.

7. Modul nach einem der vorhergehenden Ansprüche, wobei der dielektrische Träger (101) ein flexibler Träger aus der Familie der Polyimide ist.

8. Chipkarte, welche einen Kartenkörper mit einer in den Kartenkörper integrierten elektrischen Schaltung (200) und ein Modul (4) nach einem der vorhergehenden Ansprüche umfasst, wobei das Modul (4) und die Schaltung (200) mithilfe eines Schweißmaterials (6) elektrisch verbunden sind.

9. Chipkarte nach Anspruch 8, wobei das Modul (4) und die Schaltung (200) mithilfe eines auf mindestens ein Anschlusspad (7) aufgebrachten Schweißmaterials (6) elektrisch verbunden sind, dessen Schmelztemperatur kleiner oder gleich 140 °C ist.

10. Chipkarte nach Anspruch 8 oder 9, wobei das Modul (4) und die Schaltung (200) mithilfe eines auf mindestens ein Anschlusspad (7) aufgebrachten Schweißmaterials (6) und eines auf die Schaltung (200) aufgebrachten Schweißmaterials (206) elektrisch verbunden sind, wobei die Schmelztemperatur des auf mindestens ein Anschlusspad (7) aufgebrachten Schweißmaterials (6) kleiner oder gleich derjenigen des auf die Schaltung (200) aufgebrachten Schweißmaterials (206) ist.

11. Verfahren zur Herstellung eines biometrischen Sensormoduls (4) für eine Chipkarte, welche Schritte umfasst, in welchen
- ein dielektrischer Träger (101) bereitgestellt wird, der eine Vorderseite und eine Rückseite aufweist, die beide jeweils eine Hauptseite des Trägers (101) bilden,
- ein biometrischer Sensor (300) zur Erkennung digitaler Fingerabdrücke an der Rückseite angebracht wird, wobei eine von dem Sensor bedeckte Detektionsfläche auf der Rückseite gegenüber einem Detektionsbereich angeordnet wird, der sich auf der Vorderseite des Trägers (101) befindet, wobei der Detektionsbereich dafür ausgelegt ist, einen Finger aufzunehmen, dessen Abdruck von dem Sensor erkannt wird,
- elektrisch leitende Anschlusspads (7) auf der Rückseite des Trägers (101) hergestellt werden und mit dem biometrischen Sensor (300) elektrisch verbunden werden, **dadurch gekennzeichnet, dass** mindestens ein Anschlusspad (7) einen mit einem Schweißmaterial benetzbaren Bereich aufweist, der sich auf einer Fläche zwischen 0,2 und 5 Quadratmillimetern erstreckt, und dadurch, dass das Anschlusspad (7) im Wesentlichen gegenüber einem Bereich der Vorderseite angeordnet wird, der von einer Einfassung (5) bedeckt ist, und mindestens ein leitendes Kontaktloch (104) in der Dicke des Trägers (101) ausgebildet wird, wobei dieses Kontaktloch (104) die Einfassung (5) mit dem Anschlusspad (7) elektrisch verbindet.

12. Verfahren nach Anspruch 11, wobei ein Tropfen Schweißmaterial (6) auf ein Anschlusspad (7) aufgebracht wird.

13. Verfahren nach Anspruch 12, wobei das Schweißmaterial (6) durch einen Strahl auf ein Anschlusspad (7) aufgebracht wird.

14. Verfahren nach Anspruch 12 oder 13, wobei das Schweißmaterial (6) auf ein Anschlusspad (7) aufgebracht wird, nachdem der biometrische Sensor (300) an der Rückseite des Trägers (101) angebracht worden ist.

15. Verfahren nach einem der Ansprüche 11 bis 14, wobei der biometrische Sensor (300) auf der Rückseite des Trägers (101) mithilfe eines Klebstoffs zur Befestigung von Chips angebracht wird, der bei Temperaturen zwischen 100 °C und 150 °C vernetzt.

## Claims

1. Biometric sensor module for a chip card, comprising
- a dielectric carrier (101) comprising a front face and a back face, both forming main faces of the carrier (101),
- a biometric sensor (300) for detecting fingerprints which is attached to the back face and extends beneath the back face over a detection area located opposite a detection region located on the front face of the carrier (101), the detection region being configured to receive a finger the fingerprint of which is detected by the sensor,
- electrically conductive connection pads (7), arranged on the back face of the carrier (101) and electrically connected to the biometric sensor (300), **characterized in that** at least one connection pad (7) comprises a region that is wettable with a solder material, extending over an area of between 0.2 and 5 square millimetres, and **in that** the connection pad (7) is placed essentially opposite a region of the front face covered with a bezel (5), and at least one conductive via (104) is made in the thickness of the carrier (101), this via (104) electrically connecting the bezel (5) to the connection pad (7).

2. Module according to Claim 1, in which at least one connection pad (7) has a region that is wettable with a solder material and that is delimited by an essentially continuous perimeter taking a shape chosen from among a rectangle, a rhombus, a square, an oval, or a circle.

3. Module according to Claim 2, in which at least one connection pad (7) comprises extensions (10) extending from the region that is wettable with a solder material towards a free end.

4. Module according to one of the preceding claims, in which a blob of solder material (6) is deposited on the wettable region of at least one connection pad (7), this blob having a volume of between 0.002 and 0.070 cubic millimetres.

5. Module according to Claim 4, in which the solder material is an alloy having a melting temperature lower than or equal to 140°C and included in the list consisting of tin/bismuth and tin/bismuth/silver and tin/indium.

6. Module according to one of Claims 4 and 5, in which the blob of solder material (6) has a height measured perpendicular to the carrier (101), between the surface of the connection pad (7) on which it is deposited and its highest point, of between 0.040 and 0.150 millimetres.

7. Module according to one of the preceding claims, in which the dielectric carrier (101) is a flexible carrier from the polyimide family.

8. Chip card comprising a card body with an electrical circuit (200) integrated into the card body and a module (4) according to one of the preceding claims, the module (4) and the circuit (200) being electrically connected using a solder material (6).

9. Chip card according to Claim 8, in which the module (4) and the circuit (200) are electrically connected using a solder material (6) deposited on at least one connection pad (7) the melting temperature of which solder material is lower than or equal to 140°C.

10. Chip card according to Claim 8 or 9, in which the module (4) and the circuit (200) are electrically connected using a solder material (6) deposited on at least one connection pad (7) and a solder material (206) deposited on the circuit (200), the melting temperature of the solder material (6) deposited on at least one connection pad (7) being lower than or equal to that of the solder material (206) deposited on the circuit (200).

11. Method for producing a biometric sensor module (4) for a chip card, comprising steps of
- providing a dielectric carrier (101) comprising a front face and a back face, both forming main faces of the carrier (101),
- attaching a biometric sensor (300) for detecting fingerprints to the back face, a detection area covered by the sensor on the back face being placed opposite a detection region located on the front face of the carrier (101), the detection region being configured to receive a finger the fingerprint of which is detected by the sensor,
- producing electrically conductive connection pads (7) on the back face of the carrier (101) which are electrically connected to the biometric sensor (300), **characterized in that** at least one connection pad (7) comprises a region that is wettable with a solder material, extending over an area of between 0.2 and 5 square millimetres, and **in that** the connection pad (7) is placed essentially opposite a region of the front face covered with a bezel (5), and at least one conductive via (104) is made in the thickness of the carrier (101), this via (104) electrically connecting the bezel (5) to the connection pad (7).

12. Method according to Claim 11, in which a blob of solder (6) is deposited on a connection pad (7).

13. Method according to Claim 12, in which the solder material (6) is deposited by jetting on a connection pad (7).

14. Method according to Claim 12 or 13, in which the solder material (6) is deposited on a connection pad (7) after the biometric sensor (300) has been attached to the back face of the carrier (101).

15. Method according to one of Claims 11 to 14, in which the biometric sensor (300) is attached to the back face of the carrier (101) using an adhesive for attaching chips which crosslinks at temperatures of between 100°C and 150°C.
